(19) Europäisches Patentamt
European Patent Office
Office européen des brevets

(11) **EP 2 678 287 B1**

(12) **EUROPÄISCHE PATENTSCHRIFT**

(45) Veröffentlichungstag und Bekanntmachung des Hinweises auf die Patenterteilung:
**07.11.2018   Patentblatt 2018/45**

(21) Anmeldenummer: **12706523.3**

(22) Anmeldetag: **21.02.2012**

(51) Int Cl.:
*C03C 27/00 (2006.01)*     *C03C 27/06 (2006.01)*
*C03C 27/08 (2006.01)*     *C03C 23/00 (2006.01)*
*C03B 23/203 (2006.01)*    *C04B 37/04 (2006.01)*
*B23K 20/02 (2006.01)*     *B23K 20/24 (2006.01)*
*H01L 21/18 (2006.01)*     *H01L 21/20 (2006.01)*
*B32B 37/14 (2006.01)*     *C03B 23/20 (2006.01)*
*C04B 35/645 (2006.01)*    *C04B 37/00 (2006.01)*

(86) Internationale Anmeldenummer:
**PCT/EP2012/052929**

(87) Internationale Veröffentlichungsnummer:
**WO 2012/113787 (30.08.2012 Gazette 2012/35)**

(54) **VERFAHREN ZUM FÜGEN VON SUBSTRATEN**

METHOD FOR JOINING SUBSTRATES

PROCÉDÉ POUR ASSEMBLER DES SUBSTRATS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.02.2011   DE 102011012835**

(43) Veröffentlichungstag der Anmeldung:
**01.01.2014   Patentblatt 2014/01**

(73) Patentinhaber:
• **Fraunhofer-Gesellschaft zur Förderung der angewandten Forschung e.V.
80686 München (DE)**
• **Friedrich-Schiller-Universität Jena
07743 Jena (DE)**

(72) Erfinder:
• **KALKOWSKI, Gerhard
07743 Jena (DE)**
• **ROTHHARDT, Carolin
07743 Jena (DE)**
• **ROHDE, Mathias
07639 Bad Klosterlausnitz (DE)**
• **EBERHARDT, Ramona
07751 Bucha (DE)**

(74) Vertreter: **Pfenning, Meinig & Partner mbB
Patent- und Rechtsanwälte
An der Frauenkirche 20
01067 Dresden (DE)**

(56) Entgegenhaltungen:
**US-A1- 2012 013 012**

• **V. DRAGOI, G. MITTENDORFER, C. THANNER, P. LINDNER: "Wafer-level plasma activated bonding: new technology for MEMS fabrication", MICROCRYST. TECHNOL., Bd. 14, 2008, Seiten 509-515, XP019591707, DOI: 10.1007/s00542-007-0437-7**
• **Y. A. LI, R. W. BOWER: "Systematic low-temperature silicon bonding using pressure and temperature", JAPANESE JOURNAL OF APPLIED PHYSICS, Bd. 37, 1998, Seiten 737-741, XP008151767, DOI: 10.1143/JJAP.37.737**
• **T. SUNI, K. HENTTINEN, I. SUNI, J. MÄKINEN: "Effects of plasma activation on hydrophilic bonding of Si and SiO2", JOURNAL OF THE ELECTROCHEMICAL SOCIETY, Bd. 149, Nr. 6, 2002, Seiten G348-G351, XP008046162, DOI: 10.1149/1.1477209**
• **G. KALKOWSKI, S. RISSE, C. ROTHHARDT, M. ROHDE, R. EBERHARDT: "Optical contacting of low-expansion materials", PROC. SPIE 8126, 81261F, 22. August 2011 (2011-08-22), XP008151738, DOI: 10.1117/12.894382**

**Beschreibung**

Die Erfindung betrifft ein Verfahren zum Fügen von Substraten. Es können so insbesondere optisch transparente Substrate miteinander verbunden werden.

Als Substratwerkstoffe können nachfolgend genannte Werkstoffe und Materialien eingesetzt werden:

1) Gläser, die überwiegend $SiO_2$ enthalten (z. B. reines $SiO_2$ (fused silica), BK7, Pyrex 7740 oder ULE von Corning /USA), Glaskeramik (z.B. ZERODUR von Schott/Deutschland)),

2) kristallinen Materialien mit hohem Oxidanteil (z.B. Vanadate wie Yttrium-Vanadat, Granate wie z.B. Yttrium-Aluminium-Granat, jeweils auch dotiert mit beliebigen Seltenen Erden für Laseranwendungen, auch $KTiOPO_4$, $LiB_3O_5$ oder $LiNbO_3$)

3) Materialien, die überwiegend Aluminiumoxid enthalten (z.B. Saphir, auch dotiert mit anderen Elementen),

4) hochsteife gesinterte mechanische Werkstoffe wie SiC und Si-infiltriertes SiC (SiSiC),

5) Halbleiter/Infrarot-optische Materialien wie ZnSe, Si, Ge, GaAs etc.

Bei Verwendung hochwertiger Oberflächen mit den unten genauer beschriebenen Eigenschaften

a) hocheben
b) sehr geringe Rauheit

können auch sehr massive Glas-Teile (bzw. Keramiken, Laseraktive Materialien, nichtlineare optische Materialien...) zwischenschichtfrei mit dem unten beschriebenen Verfahren gefügt werden.

Dies ist in ähnlicher Form -teilweise unter dem Begriff "optical contacting" bereits bekannt geworden, siehe z.B.: US Von V. Dragoi u.a. sind in "Wafer-level plamsa activated bonding: new technology for MEMS fabrication"; Microsyst. Technol. Vol.14; (2008); Seiten 509-515; XP019591707; DOI: 10.1007/s00542-007-0437-7 Möglichkeiten zum Fügen bekannt, bei denen eine Oberflächenbearbeitung mit zusätzlicher Plasmaaktivierung angewandt werden soll. Die Druckschrift T. Suni, K. Henttinen, I. Suni, and J. Mäkinen: "Effects of Plasma Activation on Hydrophilic Bonding of Si and SiO2"; Journal of The Electrochemical Society, vol. 149, 2002, no. 6, p. G 348-G351 beschreibt ein Verfahren zum Präparieren von Oberflächen bei siliziumhaltigen Substraten.

Aufgabe der Erfindung ist es, Substrate aus Substratwerkstoffen miteinander zu fügen, ohne einen erhöhten Aufwand für eine Beschichtung mit zusätzlich durchzuführenden Beschichtungsverfahren aufwenden zu müssen und eine gute Qualität der Fügeverbindung dabei erreichen zu können.

Erfindungsgemäß wird diese Aufgabe mit einem Verfahren, das die Merkmale des Anspruchs 1 aufweist, gelöst. Vorteilhafte Ausgestaltungen der Erfindung können mit in untergeordneten Ansprüchen bezeichneten Merkmalen realisiert werden.

Es ist den bisher bekannten Verfahren nicht zu entnehmen, dass mit einem erhöhten Anpressdruck beim Fügevorgang, insbesondere während des Haltens bei der erhöhten Temperatur, deutliche Qualitätsverbesserungen erreicht werden können und ein direktes Fügen bei vielen Substratwerkstoffen dadurch erst möglich ist.

Aus dem Stand der Technik ist es nicht bekannt, dass bei geeigneter Vorbehandlung der Substrate in einem oxidierenden Niederdruck-Plasma die Festigkeit der Fügeverbindung verbessert wird oder das zusätzliche Aufbringen von dielektrischen Zwischenschichten entfallen kann, die nur zum nachfolgenden Erzielen einer festen Verbindung mit dem Verfahren des direktem Fügens aufgebracht werden. Beispielsweise soll für ZnSe nach US 2009/0294017A1 zunächst eine dünne $SiO_2$- oder $Al_2O_3$-Beschichtung zusätzlich mit einem Beschichtungsverfahren aufgebracht werden, um es danach direkt fügen zu können. Auch andere oxidische Beschichtungen ($TiO_2$, $Ta_2O_5$, $Nb_2O_5$) werden dort erwähnt).

Insbesondere wird durch das Anpressen der mikroskopische Kontakt im Fügebereich (das gegenseitige mikroskopische Eindringen der Flächen ineinander) verbessert und dadurch kann die Festigkeit der Fügeverbindung erhöht, sowie bei transmissiven optischen Anwendungen die Transmission durch die Fügeschicht hindurch verbessert werden.

Erforderlich sind nach dem erfindungsgemäßen Verfahren bei massiven Substraten folgende Verfahrensschritte:

Vorbehandlung der Fügeflächen in einem Sauerstoff-Niederdruckplasma wie unten genauer beschrieben; Anwendung möglichst hoher Anpresskräfte von wenigstens 2kPa, bevorzugt wenigstens 20 kPa bis ca. 5 MPa beim Fügevorgang, insbesondere während der Wärmebehandlung auf erhöhter Temperatur;

Ausführen des Fügevorgangs bei Unterdruckbedingungen von Maximal 10 mbar vorzugsweise < $10^{-3}$ mbar.

Unter solche Bedingungen sind insbesondere Verbindungen von Materialien möglich, die sonst nicht direkt (oder nur mit dem erheblich höheren Aufwand des Aufbringens einer zusätzlichen oxidischen Zwischenschicht) gefügt werden können.

Dies betrifft z.B. ZnSe und SiC, also Materialien ohne eine natürliche Oxidschicht an der Oberfläche, die aber bei der Erfindung durch eine Behandlung im Sauerstoffplasma aber in ausreichendem Umfang ausgebildet werden kann.

Das Sauerstoff-Plasma kann auch bei vorher metallisch (z.B. Ti) oder halbleitend (z.B. Si) oder dielektrisch (z.B. $Si_3N_4$ oder $CaF_2$) beschichteten Substraten angewendet werden, um durch die entsprechende Oxidation der Beschichtung die Fügbarkeit zu verbessern oder überhaupt erst die Voraussetzung für ein Fügen zu schaffen.

Durch eine intensive Sauerstoff-Vorbehandlung mit Niederdruckplasma (Druck 0,01 mbar - 100 mbar, vorzugsweise ca. 0,3 mbar) wird die vorhandene Oberfläche zunächst weitgehend oxidiert und beispielsweise dort vorhandener Kohlenstoff ebenfalls oxidiert und kann als CO oder $CO_2$ gasförmig entfernt werden. Die Sauerstoff-Plasmabehandlung sollte erst durchgeführt werden, nachdem eine gründliche Vorreinigung der Bauteile -wie unten genauer beschrieben- bereits erfolgt ist.

Die Sauerstoff-Plasmabehandlung wird bei einer Leistungsdichte von wenigstens 0,5 Watt/cm$^2$ und maximal 10 W/cm$^2$ (vorzugsweise ca. 5 Watt/cm$^2$) im Sauerstoff-Durchflussbetrieb durchgeführt und sollte bei Zufuhr von Sauerstoff mit mindestens 1 Standard cm$^3$/min (vorzugsweise wenigstens 10 Standard cm$^3$/min) und über einen Zeitraum von mindestens 1 min (vorzugsweise mindestens 10 min) durchgeführt werden.

Anstelle des Durchflussbetriebs kann auch eine mehrfache sukzessive Behandlung im $O_2$-Plasma mit nachfolgend jeweils kurzem Abspülen (ca. 2 min) unter de-ionisiertem/ destilliertem Wasser mit Megaschallunterstützung auf einem Drehtisch (ca. 300 Umdrehungen/min - 2000 Umdrehungen/min) und anschließendem Trockenschleudern durchgeführt werden.

Durch die beschriebene Vorbehandlung wird die unmittelbare Fügefläche in einer sehr dünnen Schicht (die nur wenige nm dick ist) oxidiert, bzw. vor der nächsten Plasmabehandlung noch mit Wassermolekülen besetzt, wodurch besonders gute Voraussetzungen für die Oxidation vorliegen.

Die Anwendung der Anpresskraft erfolgt durch geeignete Druckstempel oder Gewichte, welche die aufeinandergelegten Substrate fest gegeneinander pressen.

Dabei sollten zwischen den Substraten und die Druckstempel elastische/nachgiebige Matten aus PTFE oder expandiertem Graphit gelegt werden, um die Oberflächen vor Beschädigung zu schützen und den Druck möglichst gleichmäßig (ohne Ausübung von Biegespannungen) zu verteilen.

**Ebenheits-Anforderungen an Fügeflächen für das "Direkte Fügen"**

Die Ebenheit auf den polierten Fügeflächen kann am besten interferrometrisch ermittelt werden. Der Peak-to-Valley Wert (PV) entspricht dem Abstand zwischen höchstem und tiefstem Punkt wenn die Fläche durch eine Ausgleichsebene approximiert wird.

Grenzwerte für plane ebene Substrate:

Ebenheit besser als 1 $\mu$m PV (peak-to-valley) über 100 mm Durchmesser für massive Substrate, z.B. aus Glas mit einer
Dicke > 5 mm

Ebenheit besser als 10 $\mu$m PV (peak-to-valley) über 100 mm Durchmesser für dünnere Substrate, z.B. aus Glas mit 1 mm < Dicke < 5 mm

Ebenheit besser als 40 $\mu$m PV (peak-to-valley) über 100 mm Durchmesser für dünne Substrate, z.B. aus Glas mit einer Dicke < 1 mm

Vorzugsweise sollte die Ebenheit aber mindestens um einen Faktor 10 besser sein als diese Grenzwerte.

Bei Substraten die größer sind, soll dies über jeden gewählten Flächenausschnitt mit 100 mm Durchmesser gelten.

Bei Substraten die kleiner sind, soll dies proportional zum Durchmesser skaliert werden.

Beispiel: Ronde mit 25 mm Durchmesser, 10 mm dick

$$\text{Grenzwert} \quad \rightarrow \quad 1\,\mu\text{m}*25\,\text{mm}/100\,\text{mm} = 250\,\text{nm}$$

$$\text{Vorzugswert} \quad \rightarrow \quad \leq 250 \text{ nm}/10 = 25 \text{ nm.}$$

Bei sphärischen Fügeflächen soll dieser Sachverhalt sinngemäß übertragen werden, so dass der maximale Spalt bei Berührung der Fügeflächen nicht größer als die entsprechenden Werte eines ebenen Substrats der gleichen Ausdehnung und Wandstärke wird.

**Rauheits-Anforderungen an Fügeflächen für das "Direkte Fügen/Bonden"**

(Die Rauheit kann am besten mittels AFM (Atomic Force Mikroskop) ermittelt werden. Der Root-Mean-Square Wert (RMS) bezeichnet den mittleren quadratischen Rauheitswert (die Wurzel aus dem Mittel über die quadrierten Höhenabweichungen gegenüber einer Ausgleichsebene über eine Fläche von typischerweise $1\,\mu m * 1\,\mu m$, gelegentlich auch $10\mu m * 10\mu m$).

Grenzwerte:

Rauheit besser als 3 nm RMS (Root-Mean-Square)

Vorzugsweise sollte die RMS-Rauheit aber mindestens einen Faktor 5 besser als dieser Grenzwert sein.

**Reinigung und Plasma-Aktivierung vor dem Fügen/Bonden**

Die zu fügenden Substrate müssen neben den beschriebenen geometrischen Voraussetzungen (sehr große Ebenheit, bzw. Übereinstimmung in der Form und extrem geringe Rauheit) eine hohe Sauberkeit aufweisen. Grundsätzlich sollen sie zunächst eine gute Vorreinigung durchlaufen, die Fette, Schmutz, Polierrückstande, Salze etc. auf den Fügeflächen zuverlässig entfernt. Danach sollen die Fügeflächen keiner Berührung mehr ausgesetzt werden.
Nach der Vorreinigung erfolgt die Vorbehandlung der Oberflächen im Sauerstoffplasma
-wie oben beschrieben- zur Erzielung geeignet oxidierter Oberflächen für das direkte Fügen. Dieser Zustand ist häufig noch nicht ausreichend zum direkten Fügen/Bonden, da die Oberflächen selbst bei kurzzeitiger Lagerung in geschützter Umgebung durch kleinste Schwebstoffe/Partikel, organische Dämpfe aus der Umgebungsluft (z.B. Lösemittel oder ausgasende Plastikverpackungen etc.) sehr schnell wieder (unsichtbar) verunreinigt werden. Bereits Monolagen von Kohlenwasserstoffen können schädlich sein.
Daher sollte unmittelbar (maximal 3 h besser weniger als 1h) vor dem Fügevorgang in einer Reinraumumgebung hoher Qualität (ISO 4 oder besser) eine weitere Feinreinigung und Aktivierung der Fügeflächen durchgeführt werden.
Hierzu wird zunächst eine wässrige, chemisch unterstützte Reinigung der Fügeflächen, in Anlehnung an das bekannte RCA-Verfahren für Si-Wafer in der Halbleiterindustrie, durchgeführt.
Es werden (alkalische) $NH_4OH$-Lösungen (Ammoniak, ca. 1 Masse-% - 4 Masse-% in deionisiertem Wasser) im Wechsel mit $H_2O_2$-Lösungen (Wasserstoff-Peroxid ca. 1 Masse-% - 4 Masse-% in deionisiertem Wasser) verwendet.
Vorzugsweise werden diese Lösungen abwechselnd (jeweils ca. 2 Minuten) über die Fügeflächen gespült, während die zu reinigenden Substrate auf einem Drehtisch rotieren (ca. 300 Umdrehungen/min - 2000 Umdrehungen/min), um gelöste Partikel/Stoffe durch Zentrifugalkraft sofort nach außen weg zu schleudern.
Danach erfolgt ein Spülgang mit destilliertem oder wenigstens deionisiertem (DI) Wasser, möglichst ebenfalls unter Rotation und möglichst mit Schallwellenunterstützung im Megahertzbereich (Megasonic cleaning). Abschließend wird das gereinigte Substrat trockengeschleudert oder mit reinstem $N_2$-Gas trocken geblasen.
Der gesamte Vorgang kann ggf. mehrfach hintereinander erfolgen und es kann bereits die Einwirkung der chemischen Lösungen auf die Substratoberflächen mit Megaschallunterstützung erfolgen. Ggf. kann auch auf die alkalische Lösung verzichtet werden, um unerwünschte chemische Reaktionen auf der Oberfläche auszuschließen.
Sofort nach der Feinreinigung kann nochmals eine kurzzeitige Plasma-Aktivierung der Fügeflächen im Sauerstoff- oder Stickstoff-Plasma bei Drücken zwischen ca. 0,01 mbar und 100 mbar (vorzugsweise ca. 0,3 mbar für etwa 30 s bis 1 min) und ein Spülvorgang mit destilliertem oder de-ionisiertem Wasser mit anschließendem durch Trockenschleudern durchgeführt werden. Dadurch werden hydrophile Oberflächen erreicht, die mit OH-Gruppen gesättigt und für das anschließende direkte Fügen/Bonden besonders gut geeignet sind. Die derart aktivierten Fügeflächen sollten unmittelbar anschließend aufeinandergelegt werden und im Vakuum unter Druck und erhöhter Temperatur miteinander verbunden werden.
Die Handhabung der Substrate (vom Reinigen und Plasma-Aktivieren bis zum Aufeinanderlegen) sollte so erfolgen, dass die Fügeflächen zwischendurch nicht berührt oder anderweitig verunreinigt werden.

**Fügevorgang**

Der Fügevorgang sollte unmittelbar anschließend an die obigen Prozessschritte (Reinigung, Plasma-Aktivierung, Spülen) durchgeführt werden, um eine erneute Kontamination der Fügeflächen mit festen Partikeln oder gasförmigen Verunreinigungen aus der Umgebung zu vermeiden.

Zum Fügen werden die getrockneten Teile durch geeignetes Anpressen im Bereich der Fügeflächen in engen mechanischen Kontakt gebracht. Dies soll im Vakuum bei einem Druck von < 10 mbar, vorzugsweise < $10^{-3}$ mbar erfolgen.

Im angepressten Zustand wird der Verbund gleichmäßig erwärmt (ca. 5-10°C/min) und für eine gewisse Zeit bei einer maximalen Temperatur im Bereich von etwa 100 °C bis 600 °C, vorzugsweise etwa 250°C gehalten. Die Dauer der Wärmebehandlung kann mit zunehmender Halte-Temperatur reduziert werden. Sie sollte für eine Halte-Temperatur von 250 °C etwa 1/2 Stunde bis 24 Stunden, vorzugsweise etwa 4 Stunden betragen.

Der Anpressdruck kann in der Phase des Anwärmens niedriger sein als beim Halten auf erhöhter Temperatur, um Verspannungen und Bruch aufgrund von Spannungen, insbesondere durch thermische Ausdehnungsunterschiede zwischen Druckstempeln und Substraten zu vermeiden.

Die Anpresskraft bei der erhöhten Temperatur sollte beim Fügen von Glassubstraten im Bereich zwischen 2 kPa und etwa 5 MPa liegen, vorzugsweise aber 2 MPa betragen, um das Risiko von Spannungen/Verzerrungen in den Substraten oder gar Beschädigungen so klein wie möglich zu halten.

Sie sollte ausreichend groß sein, um die zu fügenden Substrate auf ihrer gesamten Fügefläche in engen mechanischen Kontakt zu bringen. Dies erfordert bei perfekt ebenen Flächen einen relativ geringen Druck. Bei dünnen Platten (Wafern) ist die Ebenheit gewöhnlich durch Elastizität/Flexibilität der Teile eingeschränkt, da die Oberflächenbearbeitung zwar zunächst -z.B. während des Läppens/Polierenseinen ebenen Zustand herbeiführt, danach aber wieder Verbiegungen aufgrund von inneren Spannungen/ Material-Inhomogenitäten zum Vorschein kommen können. Das Ergebnis ist häufig eine wellige Oberfläche (bei Si-Halbleiterwafern mit Bow und Warp bezeichnet), die sich aber unter hinreichendem Anpressdruck auf eine ebene Gegenfläche anschmiegen lässt.

Unbedingt zu vermeiden ist eine Biegebelastung der massiven Substrate, welche die (besonders kritische) Zugfestigkeit des Materials überschreitet. Hierzu ist es sinnvoll, durch nachgiebige (weiche/elastische) Unterlagen zwischen den zu fügenden Teilen und den Druckstempeln/ Gewichten Unebenheiten/Formabweichungen auszugleichen und eine gleichmäßige (flächige) Druckkraftverteilung auf die zu fügenden Substrate auszuüben, ohne dass hohe lokale Biegespannung auftreten.

Diese Unterlagen können z.B. Folien aus expandiertem Graphit sein (z.B. flexible Graphitfolie "SIGRAFLEX" von SGL Group, SGL CARBON SE, Rheingaustr. 182, 65203 Wiesbaden, Germany) oder Folien aus temperaturbeständigem Kunststoff (PTFE), die u.U. in mehreren Lagen übereinander gelegt werden. Die Oberflächen werden hierdurch auch vor Kratzern/Beschädigungen geschützt.

Nach ausreichender Wärmebehandlung bei erhöhter Temperatur sollte der Anpressdruck aufgehoben (oder zumindest stark vermindert) und die Temperatur dann wieder langsam (ca. 5°C/min) auf Raumtemperatur gesenkt werden.

Beim Fügen von Materialien, die in ihrer thermischen Ausdehnung sehr gut angepasst sind (weniger als 10 % Abweichung relativ zueinander im Bereich zwischen Raumtemperatur und maximaler Fügetemperatur) kann die Abkühlung auch wesentlich schneller erfolgen.

Nachfolgend soll die Erfindung beispielhaft weiter erläutert werden:
Dabei zeigen:

Figur 1    ein Beispiel von Substraten vor dem Fügen und
Figur 2    ein weiteres Beispiel von Substraten vor dem Fügen.

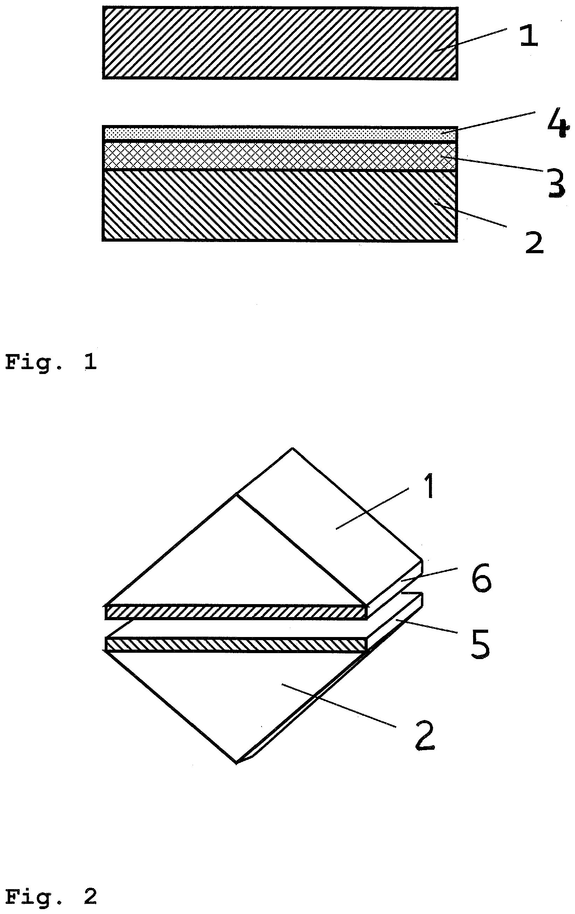

Die Figur 1 zeigt zwei Substrate vor dem Fügen (im Querschnitt, nicht maßstäblich). Die Substrate sind zwei massive Glasplatten 1, 2 wobei die Platte 2 mit einer Beschichtung 3 versehen ist und die Beschichtung 3 oberflächlich durch $O_2$-Plasmabehandlung oxidiert wurde und hierdurch eine modifizierte Zusammensetzung mit Oxidanteil in der Schicht 4 an der Oberfläche aufweist. Es ist eine Anwendung als dichroitischer Filter, Laser-Reflektor, Halteelement (Chuck), mechanische Plattform u.a.m. möglich.

Die beiden Glasplatten 1 und 2 können aus Kieselglas (fused silica), ULE oder BK7-Glas bestehen. Auf der Oberfläche der Glasplatte 2 ist eine Beschichtung 3 aus einem Metall (z.B. Nickel, Titan, Chrom, Silber) oder einer Metalllegierung in Form eines dünnen Films mit einer Schichtdicke im Bereich 10 nm bis 100 nm ausgebildet.

Durch eine Sauerstoffbehandlung im Niederdruckplasma kann ein dem Metall entsprechendes Metalloxid (NiO, $TiO_2$, $Cr_2O_3$, $Ag_2O$) unmittelbar auf der Oberfläche 4, d.h. genau an der Oberfläche, an der es für das Fügen erforderlich ist, gebildet werden. Beim Fügen wird über das gebildete Oxid eine chemische Bindung mit der Oberfläche der Glasplatte 1 erreicht.

An Stelle der Beschichtung 3 aus Metall kann auch mindestens eine Oxidschicht ausgebildet werden. Dies kann/können Schichten aus $HfO_2$, Indium-Zinn-Oxid (ITO), MgO, $Nb_2O_5$, SiO, $SiO_2$, $TiO_2$, $Ta_2O_5$ oder $ZrO_2$ sein. Sind mehrere Schichten ausgebildet können diese ein optisches Mehrfachschichtsystem bilden, bei dem im Wechsel alternierend Schichten aus einem Oxid mit höherer und niedrigerer optischer Brechzahl ausgebildet sind. Damit können so genannte Interferenzfilter für optische Anwendungen hergestellt werden. Die Schichtdicken der einzelnen Schichten können auf bestimmte Wellenlängen unter Berücksichtigung der jeweiligen optischen Brechzahlen, als $\lambda$/4-Schichten abgestimmt sein. So hat $SiO_2$ eine optische Brechzahl von ca. 1,5 und $TiO_2$ eine optische Brechzahl von ca. 2.4 für Wellenlängen elektromagnetischer Strahlung um 500 nm, also im mittleren Spektralbereich des sichtbaren Lichts.

Die Ausbildung von Schichten kann mit an sich bekannten PVD- und CVD-Verfahren erreicht werden.

Aus optischen oder mechanischen Gründen kann es vorteilhaft sein, ein Mehrschichtsystem mit einer oder mehreren Schichten auszubilden, bei denen das jeweilige Oxid nicht stöchiometrisch, bevorzugt unterstöchiometrisch ist. So kann bei $TiO_x$ und $SiO_x$ x < 2 sein. Eine Sauerstoffbehandlung mit Niederdruckplasma kann eine Aufoxidation bewirken, bei der die thermodynamisch stabileren stöchiometrischen Oxide $TiO_2$ oder $SiO_2$ unmittelbar an der Oberfläche 4 erhalten werden. Dadurch können die Fügebedingungen und die Festigkeit der Fügung verbessert werden.

Nichtstöchiometrische Oxidschichten mit einem Sauerstoffdefizit können zu anwendungsspezifischen optischen Vorteilen, z.B. einer erhöhten Absorption im Wellenlängenbereich des sichtbaren Lichts aber guter Transmission bei Wellenlängen elektromagnetischer Strahlung aus dem Spektralbereich des IR-Lichts, führen. Dies gilt beispielsweise für $SiO_x$ mit 1 < x < 2. Daneben können die Schichteigenschaften für das Fügen verbessert sein, da diese Schichten poröser und/oder deren E-Modul kleiner als der E-Modul der Substratwerkstoffe sind. Eine solche Schicht kann "anpassungsfähiger" sein.

Werden unterschiedliche Werkstoffe für die miteinander zu fügenden Substrate eingesetzt, sollten deren thermische Ausdehnungskoeffizienten berücksichtigt werden. Bei unterschiedlichen thermischen Ausdehnungskoeffizienten können mechanischen Spannungen in der Fügezone während der thermischen Behandlung und dem Anpressen auftreten, wenn dies nicht ausreichend berücksichtigt wird. Dadurch könnte eine nicht dauerhafte Verbindung von Substraten erreicht werden. Hierfür haben aber auch die Dimensionierung der Fügeflächen, die E-Module, die Geometrie der Substrate, die Biegesteifigkeit sowie die maximale Temperatur bei der Wärmebehandlung Einfluss, so dass dies für jeweilige Fälle überprüft werden sollte.

Bei Versuchen mit Kreisscheiben aus Terbium-Gallium-Granat ($Tb_3Ga_5O_{12}$), die einen Außendurchmesser von 10 mm bei einer Höhe/Dicke von 2 mm aufwiesen, zeigte sich, dass sie problemlos mit Kreisscheiben aus Saphir mit einem Außendurchmesser von 12 mm mit einer Höhe/Dicke von 2 mm bei einer maximalen Temperatur von 200 °C gefügt werden konnten. Der thermische Ausdehnungskoeffizient von Therbium-Gallium-Granat (Kubisches Kristallsystem, Ausdehnungen in alle Richtungen gleich) liegt bei $9 * 10^{-6}$ $K^{-1}$ und der von Saphir in der Ebene der miteinander zu fügenden Oberflächen (senkrecht zur optischen Achse der miteinander verbundenen Substrate) bei $6 * 10^{-6}$ $K^{-1}$. Daraus folgt, dass bei entsprechend niedrigen Temperaturen, die für das Fügen genutzt werden, auch Substrate aus unterschiedlichen Werkstoffen gefügt werden können und dabei die Verbindung dauerhaft fest ist.

Die Figur 2 zeigt ebenfalls zwei Substrate vor dem Fügen (Explosionsdarstellung, nicht maßstäblich). Die Substrate sind bei diesem Beispiel zwei massive Glasprismen 1, 2, wobei beide Prismen 1 und 2 mit unterschiedlichen Schichten 5, 6 versehen sein können (oder auch nicht beschichtet sein können) und durch eine Niederdruck $O_2$-Plasmabehandlung oder auch andere Plasmabehandlung ($N_2$-Plasma, Ar-Plasma...) auf ihren Oberflächen mikroskopisch modifiziert sind. Es ist eine Anwendung als Strahlteiler möglich.

Die bei diesem Beispiel gewählte Prismenform für die Substrate stellt eine spezielle Ausführungsform dar, die insbesondere auf Strahlteilerwürfel zugeschnitten sein kann. Es werden dabei häufig optische Mehrschichtsysteme, wie sie vorab bereits erwähnt worden sind, aufgebracht, um beispielsweise eine optische Filterwirkung zu erreichen.

An Stelle der Prismen 1 und 2 können aber auch andere Geometrien, wie z.B. Kreisscheiben, Halbkugel oder Substrate mit konkav oder konvex gekrümmter Oberfläche miteinander verbunden werden. Bei Substraten aus SiC kann das Fügen erreicht werden, wenn die miteinander zu verbindenden Oberflächen die genannten geometrischen Oberflächenverhältnisse erfüllen und vor dem Fügen eine ausreichende Plasmabehandlung mit Sauerstoff als Plasmagas durchgeführt worden ist.

Durch die Reaktion des Sauerstoffplasmas mit dem SiC kann unmittelbar an den Oberflächen die Bildung der flüchtigen/gasförmigen Kohlenstoffoxide (CO u. $CO_2$) sowie der nichtflüchtigen/festen Siliciumoxide (SiO u. $SiO_2$) erreicht werden. Im Durchflussbetrieb oder bei mehrfacher Behandlung mit dem Plasma kann der Kohlenstoff weitgehend aus den Oberflächenbereichen entfernt und durch eine dünne Siliciumoxidschicht ersetzt werden. Mit ausgebildeten Siliciumoxidschichten auf den zu fügenden Oberflächen kann das hydrophile Fügeverfahren vorteilhaft durchgeführt werden.

In analoger Form können auch Substrate aus anderen Werkstoffen, wie z.B. SiC mit Silicium oder Silicium mit Pyrex-Glas (z.B. Typ 7740 von Corning), so miteinander durch Fügen verbunden werden.

**Patentansprüche**

1. Verfahren zum Fügen von Substraten, bei dem
eine Glättung der Oberflächen im Fügebereich von Substraten so durchgeführt wird, dass
eine Ebenheit oder eine Abweichung der Oberfläche von Fügeflächen mit
einer Oberflächenrauheit < 3 nm RMS, bevorzugt < 1 nm eingehalten ist; und
eine Vorbehandlung mindestens einer Fügefläche eines zu fügenden Substrats in einem Sauerstoff-Niederdruckplasma vor dem eigentlichen Fügen durchgeführt wird, wobei beim Fügen auf die zu fügenden Substrate eine Anpresskraft im Bereich 2 kPa bis 5 MPa wirkt und dabei eine Wärmebehandlung auf erhöhter Temperatur von mindestens 100 °C und bei Unterdruckbedingungen von maximal 10 mbar, vorzugsweise < $10^{-3}$ mbar durchgeführt wird, wobei die Vorbehandlung mit Sauerstoff-Niederdruckplasma mit einer Leistungsdichte im Bereich 0,5 W/cm$^2$ bis 10 W/cm$^2$ durchgeführt wird.

2. Verfahren nach Anspruch 1, **dadurch gekennzeichnet, dass** Substrate gefügt werden, die aus einem Glas, in dem überwiegend $SiO_2$ enthalten ist, ULE-Glas, Glaskeramik, kristallinen Materialien mit hohem Oxidanteil, wie Vanadate, insbesondere Yttrium-Vanadat, Granate, insbesondere Yttrium-Aluminium-Granat, $KTiOPO_4$, $LiB_3O_5$ oder $LiNbO_3$, Aluminiumoxid, insbesondere Saphir, SiC, SiSiC, ZnSe, Si, Ge oder GaAs gebildet sind.

3. Verfahren nach einem der vorhergehenden Ansprüche, **dadurch gekennzeichnet, dass** eine Reinigung durch alternierendes Spülen mit wässrigen $NH_4OH$-Lösung und $H_2O_2$-Lösung, mit einer jeweiligen Konzentration im Bereich 2 % - 4 %, ein anschließendes Spülen in destilliertem oder deionisiertem Wasser unter gleichzeitiger Einwirkung von Schallwellen im Megahertzbereich und einem anschließendem Trocknen durchgeführt wird.

4. Verfahren nach einem der vorhergehenden Ansprüche, **dadurch gekennzeichnet, dass** die Vorbehandlung mit Sauerstoff-Niederdruckplasma im Durchlauf oder mit mehrfacher sukzessiver Plasmabeaufschlagung über einen Zeitraum von mindestens 60 s durchgeführt wird.

5. Verfahren nach einem der vorhergehenden Ansprüche, **dadurch gekennzeichnet, dass** im Anschluss an die Plasmabehandlung ein Spülen in destilliertem oder de-ionisiertem Wasser unter gleichzeitiger Einwirkung von Schallwellen im Megahertzbereich und einem anschließendem Trocknen durchgeführt wird.

6. Verfahren nach einem der vorhergehenden Ansprüche, **dadurch gekennzeichnet, dass** auf mindestens eine Fügefläche mindestens eines Substrats eine Oberflächenschicht aus Metall, einem Halbleiter oder einem dielektrischen Werkstoff vor dem Fügen ausgebildet wird.

7. Verfahren nach Anspruch 6, **dadurch gekennzeichnet, dass** auf mindestens eine Oberfläche ein alternierendes Mehrschichtsystem mit Einzelschichten aus Werkstoffen mit unterschiedlicher optischer Brechzahl ausgebildet wird.

8. Verfahren nach Anspruch 6 oder 7, **dadurch gekennzeichnet, dass** mindestens eine Schicht eines nichtstöchiometrischen Oxids ausgebildet wird.

**Claims**

1. A method of joining substrates, wherein
a smoothing of surfaces in the joining area of substrates is carried out such that an evenness or a deviation of the surface of joining surfaces with a surface roughness of < 3 nm RMS, preferably < 1 nm, is observed; and a pretreatment of at least one joining surface of a substrate to be joined is carried out prior to the actual joining in a low pressure oxygen plasma, wherein during the joining a pressing force in the range of 2 kPa to 5 MPa acts on the substrates to be joined and in so doing a heat treatment is carried out at an elevated temperature of at least 100°C and under underpressure conditions of a maximum of 10 mbar, preferably < $10^{-3}$ mbar, wherein the pretreatment with low pressure oxygen plasma is carried out with a power density in the range from 0.5 W/cm$^2$ to 10 W/cm$^2$.

2. A method in accordance with claim 1, **characterized in that** substrates are joined which are formed from a glass in which predominantly $SiO_2$ is contained, ULE glass, glass ceramics, crystalline materials with a high oxide content such as vanadates, in particular yttrium vanadate, garnets, in particular yttrium aluminum garnet, $KTiOPO_4$, $LiB_3O_5$ or $LiNbO_3$, aluminum oxide, in particular sapphire, SiC, SiSiC, ZnSe, Si, Ge or GaAs.

3. A method in accordance with one of the preceding claims, **characterized in that** a cleaning is carried out by alternate rinsing with aqueous NH$_4$OH solution and H$_2$O$_2$ solution having a respective concentration in the range of 2% to 4%, by subsequent rinsing in distilled or deionized water with a simultaneous exposure to sound waves in the megahertz range and a subsequent drying.

4. A method in accordance with one of the preceding claims, **characterized in that** the pretreatment with low pressure oxygen plasma is carried out in a continuous process or with a multiple successive plasma action over a time period of at least 60 s.

5. A method in accordance with one of the preceding claims, **characterized in that** subsequent to the plasma treatment a rinsing is carried out in distilled or deionized water under the simultaneous exposure to sound waves in the megahertz range and with a subsequent drying.

6. A method in accordance with one of the preceding claims, **characterized in that** a surface layer of metal, a semiconductor or a dielectric material is formed on at least one joining surface of at least one substrate prior to the joining.

7. A method in accordance with one of the preceding claims, **characterized in that** an alternating multilayer system having individual layers of materials having a different index of refraction is formed on at least one surface.

8. A method in accordance with one of the preceding claims, **characterized in that** at least one layer of a non-stoichiometric oxide is formed.

**Revendications**

1. Procédé pour assembler des substrats, dans lequel on procède à un lissage des surfaces dans la zone d'assemblage de substrats de façon à respecter une planéité ou une anomalie de la surface de substrats d'assemblage correspondant à une rugosité moyenne quadratique < 3 nm, de préférence < 1 nm ; et
on procède à un prétraitement d'au moins une surface d'assemblage d'un substrat à assembler, avant l'assemblage proprement dit, dans un plasma d'oxygène basse pression, une force d'appui comprise dans la plage de 2 kPa à 5 MPa agissant lors de l'assemblage sur les substrats à assembler, un traitement thermique étant réalisé à une température élevée d'au moins 100 °C et dans des conditions de dépression correspondant à un maximum de 10 mbar, de préférence < 10$^{-3}$ mbar, le prétraitement par un plasma d'oxygène basse pression étant réalisé avec une densité de puissance comprise dans la plage de 0,5 W/cm$^2$ à 10 W/cm$^2$.

2. Procédé selon la revendication 1, **caractérisé en ce qu'**on assemble des substrats qui sont formés à partir d'un verre contenant essentiellement du SiO$_2$, de verre ULE, de la vitrocéramique, des matériaux cristallins à haute teneur en oxyde tels que les vanadates, en particulier le vanadate d'yttrium, des grenats, en particulier le grenat d'yttrium et d'aluminium, KTiOPO$_4$, LiB$_3$O$_5$ ou LiNbO$_3$, l'oxyde d'aluminium, en particulier le saphir, SiC, SiSiC, ZnSe, Si, Ge ou GaAs.

3. Procédé selon l'une des revendications précédentes, **caractérisé en ce qu'**on procède à un nettoyage par rinçage alterné avec une solution aqueuse de NH$_4$OH et une solution aqueuse de H$_2$O$_2$, chacune à une concentration comprise dans la plage de 2 % à 4 %, puis à un rinçage dans de l'eau distillée ou désionisée, simultanément sous l'action d'ondes acoustiques dans la gamme des mégahertz, puis à un séchage.

4. Procédé selon l'une des revendications précédentes, **caractérisé en ce que** le prétraitement par un plasma d'oxygène basse pression est réalisé par passage direct, ou par plusieurs applications successives de plasma sur un laps de temps d'au moins 60 s.

5. Procédé selon l'une des revendications précédentes, **caractérisé en ce que**, après le traitement par plasma, on procède à un rinçage dans de l'eau distillée ou désionisée, simultanément sous l'action d'ondes acoustiques dans la gamme des mégahertz, puis à un séchage.

6. Procédé selon l'une des revendications précédentes, **caractérisé en ce qu'**on forme avant l'assemblage, sur au moins une surface d'assemblage d'au moins un substrat, une couche superficielle d'un métal, d'un semi-conducteur ou d'un matériau diélectrique.

**7.** Procédé selon la revendication 6, **caractérisé en ce qu'**on forme sur au moins une surface un système multicouche alterné comportant des couches individuelles de matériau présentant des indices de réfraction optiques différents.

**8.** Procédé selon la revendication 6 ou 7, **caractérisé en ce qu'**on forme au moins une couche d'un oxyde non stoechiométrique.

Fig. 1

Fig. 2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20090294017 A1

**In der Beschreibung aufgeführte Nicht-Patentliteratur**

- **VON V. DRAGOI.** Wafer-level plamsa activated bonding: new technology for MEMS fabrication. *Microsyst. Technol.,* 2008, vol. 14, 509-515

- **T. SUNI ; K. HENTTINEN ; I. SUNI ; J. MÄKINEN.** Effects of Plasma Activation on Hydrophilic Bonding of Si and SiO. *Journal of The Electrochemical Society,* 2002, vol. 149 (6), G 348-G351